# EUROPÄISCHE PATENTSCHRIFT

(11) **EP 0 593 931 B1**
(45) Veröffentlichungstag und Bekanntmachung des Hinweises auf die Patenterteilung: **22.04.1998**
(21) Anmeldenummer: 93115362.1
(22) Anmeldetag: 23.09.1993
(51) Int. Cl.: H01J 37/32, H05H 1/46

(54) **Vorrichtung zur Erzeugung von Mikrowellenplasmen**
Microwave plasmas producing device
Dispositif de production de plasmas micro-ondes

(30) Priorität: 23.10.1992 DE 4235914
(43) Veröffentlichungstag der Anmeldung: 27.04.1994
(73) Patentinhaber: Engemann, Jürgen Prof. Dr.-Ing., D-42119 Wuppertal (DE)
(72) Erfinder: Engemann, Jürgen, Prof. Dr. Ing., D-42119 Wuppertal (DE); Werner, Frank, Dipl.-Phys., D-42285 Wuppertal (DE)
(74) Vertreter: Patentanwälte Ostriga & Sonnet

(56) Entgegenhaltungen:
- EP-A- 0 398 832
- EP-A- 0 564 359
- FR-A- 2 583 250
- FR-A- 2 668 676
- PATENT ABSTRACTS OF JAPAN vol. 13, no. 476 (E-837)16. Oktober 1989 & JP-A-01 187 824 (HITACHI LTD) 27. Juli 1989

## Beschreibung

Die Erfindung bezieht sich auf eine Vorrichtung zur Plasmaerzeugung nach dem Oberbegriff der Patentansprüche 1 und 2.

Chemisch reaktive Niederdruck-Plasmaprozesse sind bereits Standardverfahren bei der Beschichtung und Ätzung von Halbleiterscheiben. Neben der Bearbeitung von flachen Substraten werden solche Prozesse auch für die Behandlung von Gegenständen mit komplexen Formen, wie z.B. von Formteilen aus Kunststoffen, Faserbündeln und bahnförmigen Materialien, verwendet. Es stehen bereits Verfahren und Anlagen zur Verfügung, die zur Plasmabehandlung von Substraten mit solcher Formen verwendet werden.

Durch DE 31 17 257 C2 ist eine Vorrichtung zur Plasmadeposition von dünnen Schichten bekannt, in der die Mikrowellenleistung aus einem rechteckigen Hohlleiter durch ein Koppelfenster aus Dielektrikum in eine zylindrische Resonanz- und gleichzeitig Plasmakammer eingestrahlt wird. Vorrichtungen dieser Art, auch solche die mit Luftspulen oder Verbunden aus Permanentmagneten um die Plasmakammer, zwecks Erzeugung der Elektronen-Zyklotron-Resonanz ausgestattet sind, produzieren einen gerichteten Plasmastrahl, der zur Bearbeitung von vorzugsweise scheibenförmigen Substraten verwendet wird. Große Substrate lassen sich nur durch Bewegung in dem Plasmastrahl oder durch einen gleichzeitigen Einsatz mehrerer Plasmaquellen bearbeiten.

Es ist durch DE 40 37 091 A1 eine Vorrichtung für die Erzeugung eines regelmäßigen Mikrowellenfeldes gegeben, die die Zündung eines über eine längere Strecke homogenen Plasmas ermöglicht. Dies wird durch die Auskopplung der Mikrowellenleistung durch eine Reihe von vorzugsweise induktiven Koppelantennen aus einem rechteckigen oder zylindrischen Resonator erreicht. Vakuumseitig befinden sich die Antennen im Kontakt mit dem Plasma, infolgedessen eine Kontamination der Substrate mit dem Antennenmaterial nicht zu vermeiden ist. Obwohl mit der genannten Vorrichtung die Bearbeitung von großflächigen Substraten möglich ist, wird vielmehr eine Vorrichtung gesucht, die großvolumige Substrate gleichzeitig von allen Seiten plasmabehandelt.

Durch FR-A-2 112 733 ist eine Vorrichtung für eine gleichmäßige Mikrowellenleistungseinkopplung in ein zylindrisches Volumen bekannt, in der eine stehende Welle in einer meist mäanderförmigen, in einen Zylinder eingearbeiteten Schlitzantenne erzeugt wird. Die Verbindung eines Mikrowellengenerators mit der Antenne kann nur mit einem koaxialen Kabel realisiert werden. Dies begrenzt die Möglichkeit einer Hochskalierung für solch eine Anregungsart, weil die mit einem Kabel langzeitstabil transferierbare Leistung einige hundert Watt nicht überschreiten darf.

Durch EP 0 209 469 A1 ist eine Vorrichtung zur Erzeugung eines Elektron-Zyklotron-Resonanz-Plasmas bekannt, in der die Einkopplung der Mikrowellenleistung aus mehreren Antennen erfolgt, die sich an der Wand der Plasmakammer befinden. Die Plasmakammer ist von Permanentmagneten umgeben, welche in der Nähe der Antennen Elektronen-Zyklotron-Resonanz-Bereiche erzeugen. Infolge der Ionenzerstäubung stellen die direkt dem Plasma ausgesetzten Antennen eine Quelle metallischer Kontamination dar. Um dies zu vermeiden, wurden in einer durch EP 0 402 282 A2 gegebenen Vorrichtung Abschirmungsplatten zwischen den Antennen und dem Plasma angebracht, die das zerstäubte Material auffangen sollen. Die nachteilige Wirkung der Zerstäubung des Antennenmaterials wird dadurch reduziert, aber nicht vollständig aufgehoben. Nachteil der beiden Konstruktionen ist die Art der Verteilung der Mikrowellenleistung auf die Antennen. Die Vorrichtung zur Leistungssplittung aus einem Hohlleiter auf die entsprechenden Verbindungskabel garantiert keine gleichmäßige Auskopplung der Mikrowellenleistung und dadurch auch kein zylindersymmetrisches Plasma.

Eine direkte Einkopplung der Mikrowellenleistung aus einem rechteckigen Hohlleiter in einen ringförmigen Resonator ist durch EP 0 398 832 A1 gegeben. Die dielektrische Innenwand des Resonators erfüllt hierbei gleichzeitig die Funktion einer Plasmakammerwand, durch die die Mikrowellenleistung in das Plasma eingekoppelt wird. Die flachen Seiten des ringförmigen Resonators sind als Kurzschlußschieber ausgeführt, mit denen die optimalen Resonanzbedingungen eingestellt werden. Die Ausführung der Plasmakammer aus Dielektrikum begrenzt die realistisch erreichbaren Dimensionen der zu bearbeitenden Substrate. Außerdem ist eine aufwendige Mechanik nötig, um die Abstimmung des Resonators durchzuführen.

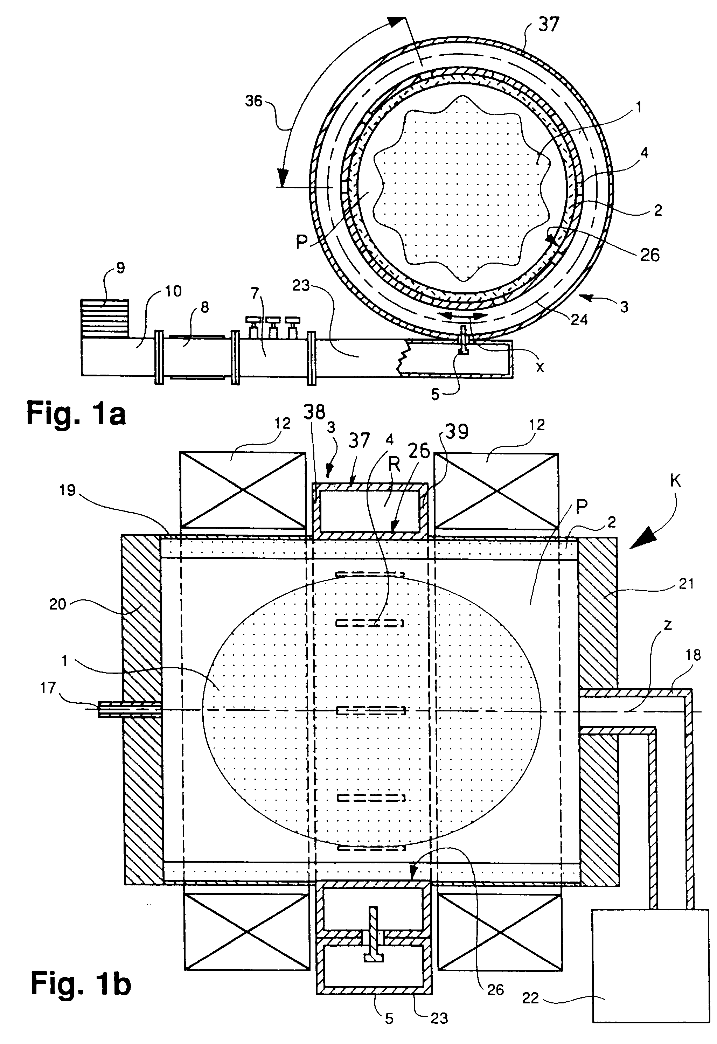

In der EP-A-0 564 359 (Art. 54(3)EPC) ist ein Resonator kreisartiger Grundform beschrieben, welcher an mindestens einer Umfangsstelle durch eine Reflektionsplatte (z.B. Fig. 1, Pos. 18) unterbrochen bzw. abgeschottet ist. Die EP-A-0 564 359 zeigt deshalb keinen kreisringförmigen Hohlleiter-Resonator. Im Vergleich zu einem zirkular offenen Ringresonator wird in der Anordnung gemäß der EP-A-0 564 359 die Lage der Wellen durch die Reflektionsplatte festgelegt, so daß die Wellen bezüglich der äquidistant angeordneten Koppelschlitze (s. Fig. 1, Pos. 14) immer in einem bestimmten festgelegten geometrischen Verhältnis stehen. Der Abstand der Koppelschlitze ist z.B. kleiner oder gleich einer Halbwellenlänge. In einem zirkular offenen Ringresonator gemäß der Erfindung paßt sich die Lage der Wellen selbsttätig an die Impedanz des Plasmas an und somit nehmen die Wellen immer eine optimale Lage zu den Koppelschlitzen ein.

In der FR-A-2 668 676 ist keine geschlossene Plasmakammer sondern ein offener Behälter (Fig. 1 bis 3, Pos. 2, 3, 4, 5, 6, 7) beschrieben. Dabei tritt die Energie radial über einen Kanal (Fig. 1, Pos. 5) in einen Ringraum (Fig. 1 bei Pos. 4) und von dort in ein relativ breites Kuppelfenster (Fig. 1, Pos. 22) eines zentralen kreiszylindrischen Kanals (Fig. 1, Pos. 7) ein. Außer dem Kuppelfenster (Fig. 1, Pos. 22) weist der zentrale kreiszylindrische Kanal 7 im Abstand einer halben Wellenlänge voneinander angeordnete Schlitze (Fig. 1, Pos. 2, 3, 23c, 23b) auf, die als Korrekturelemente angesehen werden können.

Der Erfindung liegt die Aufgabe zugrunde, eine Vorrichtung zur Erzeugung eines insbesondere großvolumigen Niederdruckplasmas anzugeben, die eine genügend hohe Plasmadichte (bis einige 1012 cm-3) aufweist und bei Vermeidung unerwünschter Kontamination die Bearbeitung von großvolumigen Substraten gleichzeitig von allen Seiten ermöglicht.

Diese Aufgabe wird durch die Merkmale der Ansprüche 1 und 2 gelöst.

Die Erfindung wird anhand der in den Zeichnungen dargestellten Ausführungsbeispiele näher erläutert. Es zeigen
Fig. 1a einen Schnitt in der Ebene senkrecht zur Längsachse der Plasmakammer zur Verdeutlichung des Prinzips einer Vorrichtung zur Plasmaerzeugung,
Fig. 1b die Vorrichtung gemäß Fig. 1a im Axialschnitt,
Fig. 2 das Prinzip der Leistungsauskopplung aus einem ringförmigen Hohlleiterresonator,
Fig. 3 im Schnitt ein Koppelelement an einer Prozeßkammer aus Metall und
Fig.4 im Schnitt eine Vorrichtung zur Mikrowelleneinkopplung in das Plasma nach Anspruch 18 mit drei ringförmigen Hohlleiterresonatoren.

In den Fig.1a und 1b ist ein Ausführungsbeispiel der Vorrichtung nach Anspruch 11 zu sehen. Eine Vakuum-bzw. Plasmakammer K, bestehend aus einem Quarzzylinder 2 und zwei Abschlußflanschen 20 und 21, wird durch einen Vakuumanschluß 18 von einer Vakuumpumpe 22 auf einen Restdruck abgepumpt.

Anschließend wird in die Vakuumkammer K durch den Gaseinlaß 17 ein Arbeitsgas eingeführt. Der sich dabei stabilisierende Druck kann in Abhängigkeit von dem eingesetzten Pumpsystem und der Abpumpzeit zwischen 10-5 und 100 mbar betragen. Die in einer Magnetron-Vakuumröhre 9 erzeugte Mikrowellenleistung mit einer Frequenz, die typischerweise 2,45 GHz beträgt, wird in einen Hohlleiter 10 eingespeist.

Durch einen Zirkulator 8, eine als Dreistift-Tuner 7 ausgebildete Abstimmeinheit, einen rechteckigen Hohlleiter 23 und einen kapazitiven Koppler 5 wird die Mikrowellenleistung in den ringförmige Hohlleiterresonator 3 geleitet.

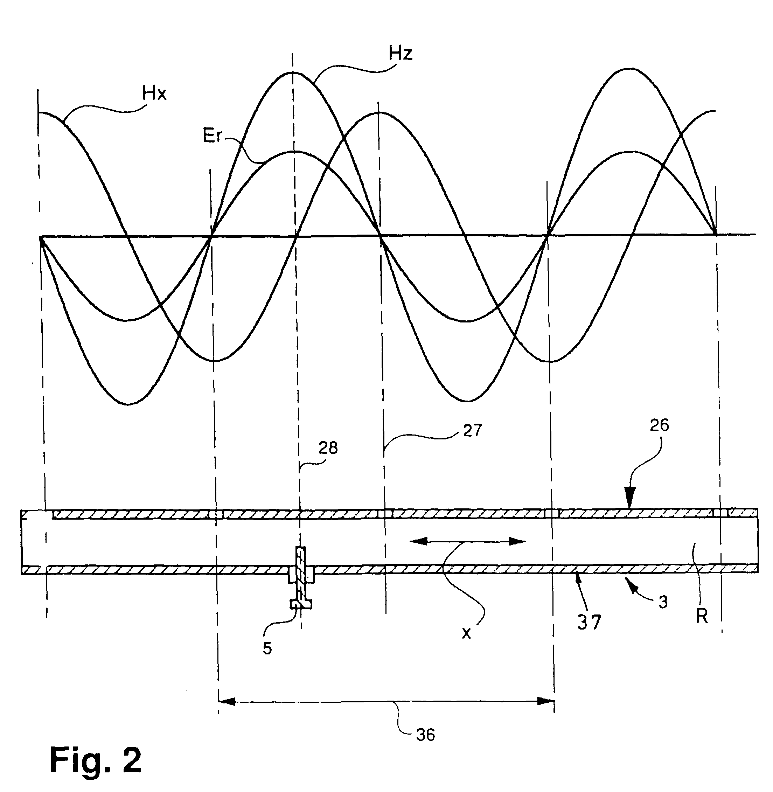

Der Durchmesser des ringförmigen Hohlleiters 3 mit dem Ringraum R ist so gewählt, daß sich in ihm eine stehende TE10 Mikrowelle ausbildet. Der metallene kreisringförmige Hohlleiterresonator 3 weist eine äußere Kreiszylindermantelwand 37, eine innere Kreiszylindermantelwand 26 sowie die beiden Kreiszylindermantelwände 37, 26 miteinander verbindende ebene Kreisringwände 38, 39 auf. Im gezeigten Ausführungsbeispiel beträgt die auf die Mitte (Kreis 24) des ringförmigen Hohlleiters bezogene Länge fünf Hohlleiterwellenlängen 36 (s. Fig. 2), bei der Voraussetzung, daß der ringförmige Hohlleiter 3 mit Luft unter Normaldruck gefüllt ist.

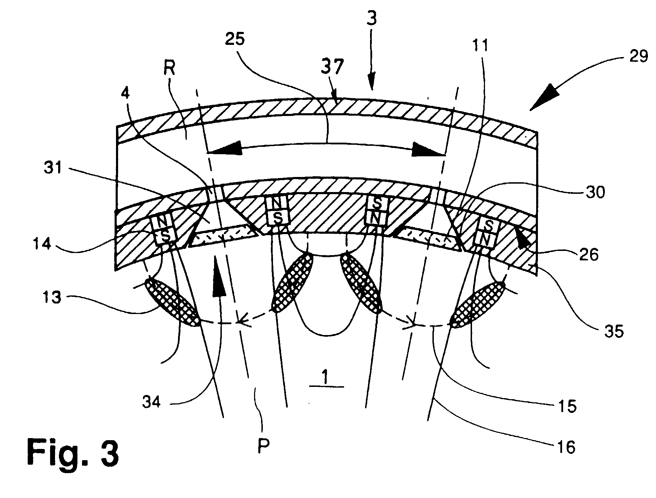

In der Innenwand 26 des ringförmigen Hohlleiterresonators 3 befinden sich in gleichen Abständen von einer halben Hohlleiterwellenlänge 25 (s. Fig. 3; vgl. Anspruch 4), bezogen auf den Kreis 24 in der Mitte des ringförmigen Hohlleiterresonators 3, die zu der Richtung x der Wellenausbreitung senkrechten Koppelschlitze 4. Die in Richtung der Kreiszylinder-Mantellinie gemessene Länge der Koppelschlitze beträgt jeweils eine halbe Freiraumwellenlänge.

Dadurch, daß der kapazitive Koppler 5 genau in der Mitte zwischen zwei Koppelschlitzen 4 liegt, wird sich die stehende Welle in dem Ringraum R des Hohlleiterresonators 3 so ausbilden, daß an den Koppelschlitzen 4 die azimutale Komponente des hochfrequenten H-Feldes Hx ihr Maximum 27 und die z-Komponente des H-Feldes Hz und die radiale Komponente des E-Feldes Er deren Minimum 28 erreichen (siehe Fig.2). Infolgedessen wird die Auskopplung der Mikrowellenleistung durch den Durchgriff der azimutalen Komponente des H-Feldes Hx durch die Koppelschlitze 4 stattfinden. Die eingestrahlten Mikrowellen verursachen die Zündung eines sehr intensiven Niederdruckplasmas 1 in einem von der Innenwand 26 des ringförmigen Hohlleiterresonators 3 umschlossenen kreiszylindrischen Raum P. Nach Anspruch 3 können sich die Koppelschlitze 4 auch in gleichen Abständen von einer Hohlleiterwellenlänge 36 befinden. Um den Austritt der Mikrowellen von der Plasmakammer nach außen zu vermeiden, ist der Quarzzylinder 2 mit einer elektrisch leitenden Abschirmung 19 (s. Fig. 1b) umhüllt.

In der nach Anspruch 11 ausgeführten Vorrichtung erreichen die Ionenkonzentrationen Werte von 1011 bis 1012 cm-3 im Druckbereich von 0,1 bis 10 mbar. Es ist jedoch häufig erwünscht, ein sehr dichtes Plasma auch bei niedrigen Drücken (unter 10-3 mbar) zu erzeugen. Durch die Elektronen-Zyklotron-Resonanz kann eine Verstärkung der Entladungsintensität hervorgerufen werden. Dies kann gemäß den Ansprüchen 13 und 14 mit Magnetspulen 12 oder gemäß Anspruch 15 mit einem Konfinement aus Permanentmagneten erreicht werden.

Die Ausführung der Erfindung nach Anspruch 11 berücksichtigt den Umstand, daß die Plasmakammer K keinen extrem großen Durchmesser (immerhin aber mehrere Dezimeter) haben kann, weil ansonsten die dielektrische Wand der Plasmakammer 2 sehr dick werden würde. Die Ausführung der Erfindung nach Anspruch 16 ermöglicht hingegen eine praktisch unbegrenzte Hochskalierung in den Dimensionen der Plasmakammer K.

Demzufolge ist in Fig.3 ein sich wiederholendes Segment 29 für die Einkopplung der Mikrowellenleistung in der Vorrichtung nach Anspruch 16 dargestellt. Die Permanentmagnete 14 sind in diesem Ausführungsbeispiel innerhalb der metallenen Plasmakammerwand 35 so positioniert, daß die Linien des hochfrequenten elektrischen Feldes 15 sich mit den Linien des statischen Magnetfeldes 16 überkreuzen. Eine solche Anordnung sichert eine optimale Übertragung der Mikrowellenschwingungen auf die sich auf spiralförmigen Trajektorien im Plasma fortbewegenden Elektronen. Die Fenster 11 aus 99,7% Al2O3-Keramik oder Quarzglas werden mit einer Weichmetall-Dichtung 30 vakuummäßig abgedichtet. Die Mikrowelle wird von den Koppelschlitzen 4 in der Innenwand 26 des ringförmigen Hohlleiterresonators 3 heraus bis in das Plasma durch einen kurzen rechteckigen Hornstrahler 31 geführt. Die aus den Koppelschlitzen 4, den Hornstrahlern 31 und den Koppelfenstern 11 aus Dielelektrikum, wie z.B aus Quarzglas, gebildeten Anordnungen sind jeweils insgesamt als Schlitzkoppler 34 bezeichnet.

Bei anderen Ausführungsformen ist es im Unterschied zur Ausführungsform gemäß Fig. 3 bei Wahl einer zweckmäßigen Befestigungsart für die Magnetanordnungen 14 und einer geänderten vakuummäßigen Abdichtung für die dielektrischen Kopplungsfenster 11 denkbar, die metallene Wand 35 wesentlich dünner auszubilden.

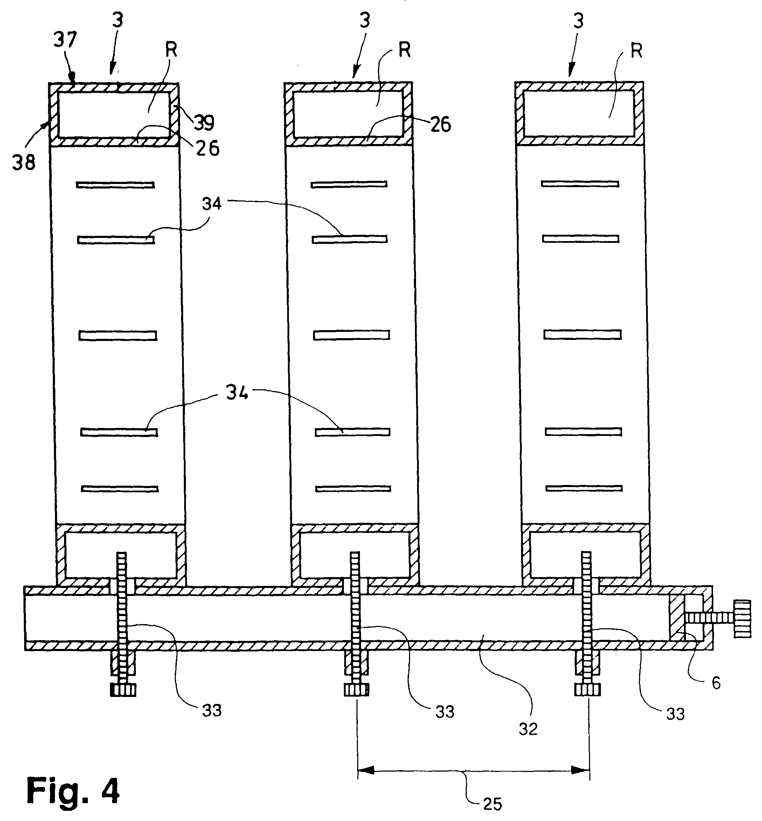

Es sind zudem Anwendungen der Erfindung denkbar, bei denen nicht nur der Durchmesser sondern auch die Länge des plasmaerzeugenden Bereiches eine Rolle spielen. In einem solchem Fall läßt sich die erfindungsgemäße Vorrichtung nach dem Anspruch 18 ausführen. Ein Ausführungsbeispiel mit drei ringförmigen Hohlleiterresonatoren 3, die an einem rechteckigen Speiseresonator 32 mit in Axialrichtung (z.B. mittels Gewinde) verstellbaren Koppelstiften 33 angeschlossen sind, ist in Fig.4 dargestellt.

Um eine kohärente Mikrowelleneinkopplung zu erreichen, befinden sich die verstellbaren Koppelstifte 33 in einem Abstand von einer Hohlleiterwellenlänge 36 voneinander. Durch Verstellung der Koppelstifte 33 läßt sich eine gleichmäßige Auskopplung der Mikrowellenleistung in die einzelnen ringförmigen Hohlleiterresonatoren 3 bewirken. Zur optimalen Einstellung einer stehenden Welle in dem rechteckigen Speiseresonator 32 dient ein Kurzschlußschieber 6 an einer Seite des Speiseresonators 32.

## Patentansprüche

1. Vorrichtung für die Erzeugung eines Niederdruckplasmas (1) mit einer Plasmakammer (K), einem Mikrowellenerzeuger (9), einem kreisringförmigen Hohlleiterresonator (3) und einer Ankopplung (23, 8, 7 und 10) des Mikrowellenerzeugers (9) an den ringförmigen Hohlleiterresonator (3), gekennzeichnet durch mehrere Koppelschlitze (4), die in der inneren Wand (26) des ringförmigen Hohlleiterresonators (3) derart angeordnet sind, daß sie jeweils gleichviel Mikrowellenleistung aus dem ringförmigen Hohlleiterresonator (3) auskoppeln, in welchem eine stehende Welle erzeugt wird und die Koppelschlitze (4) parallel zur Mantellinie der kreiszylindrischen Innenwand (26) des ringförmigen Hohlleiterresonators (3) verlaufen und äquidistant im Abstand einer Hohlleiterwellenlänge (36) voneinander angeordnet sind.

2. Vorrichtung für die Erzeugung eines Niederdruckplasmas (1) mit einer Plasmakammer (K), einem Mikrowellenerzeuger (9), einem kreisringförmigen Hohlleiterresonator (3) und einer Ankopplung (23, 8, 7 und 10) des Mikrowellenerzeugers (9) an den ringförmigen Hohlleiterresonator (3), gekennzeichnet durch mehrere Koppelschlitze (4), die in der inneren Wand (26) des ringförmigen Hohlleiterresonators (3) derart angeordnet sind, daß sie jeweils gleichviel Mikrowellenleistung aus dem ringförmigen Hohlleiterresonator (3) auskoppeln, in welchem eine stehende Welle erzeugt wird und die Koppelschlitze (4) parallel zur Mantellinie der kreiszylindrischen Innenwand (26) des ringförmigen Hohlleiterresonators (3) verlaufen und äquidistant im Abstand einer halben Hohlleiterwellenlänge (36) voneinander angeordnet sind.

3. Vorrichtung nach Anspruch 1 oder 2, dadurch gekennzeichnet, daß die Koppelschlitze (4) durch den Durchgriff der azimutalen Komponente des Magnetfeldes (Hx) die Energie aus einer im ringförmigen Hohlleiter-resonator (3) stehenden TE10-Welle auskoppeln.

4. Vorrichtung nach Anspruch 3, dadurch gekennzeichnet, daß die Länge der Koppelschlitze (4) je eine halbe Freiraumwellenlänge beträgt.

5. Vorrichtung nach einem der Ansprüche 1 bis 4, dadurch gekennzeichnet, daß die Einspeisung der Mikrowellenenergie aus der Abstimmeinheit (7) in den ringförmigen Hohlleiterresonator (3) durch einen kapazitiven Auskoppler (5) erfolgt.

6. Vorrichtung nach einem der Ansprüche 1 bis 5, dadurch gekennzeichnet, daß die Einspeisung der Mikrowellenenergie aus der Abstimmeinheit (7) in den ringförmigen Hohlleiterresonator (3) durch einen induktiven Auskoppler erfolgt.

7. Vorrichtung nach einem der Ansprüche 1 bis 6, dadurch gekennzeichnet, daß die Einspeisung der Mikrowellenenergie aus der Abstimmeinheit (7) in den ringförmigen Hohlleiterresonator durch einen insbesondere in Axialrichtung verstellbaren Koppelstift (33) erfolgt.

8. Vorrichtung nach einem der Ansprüche 1 bis 7, dadurch gekennzeichnet, daß die Plasmakammer (K) von der Innenwand (26) des ringförmigen Hohlleiterresonators (3) durch einen Zylinder aus Dielektrikum (2) abgegrenzt ist.

9. Vorrichtung nach Anspruch 8, dadurch gekennzeichnet, daß der Zylinder (2) aus Quarzglas oder aus Aluminium-Oxid-Keramik besteht.

10. Vorrichtung nach einem der Ansprüche 1 bis 7, dadurch gekennzeichnet, daß die Einkopplung der Mikrowellenleistung in eine Plasmakammer (K) aus Metall durch vakuumdichte Fenster (11) aus Dielektrikum erfolgt.

11. Vorrichtung nach einem der Ansprüche 1 bis 10, dadurch gekennzeichnet, daß von einer Seite des ringförmigen Hohlleiterresonators (3) eine Magnetspule (12) zur Erzeugung der Elektronen-Zyklotron-Resonanz-Zonen (13) angebracht ist.

12. Vorrichtung nach einem der Ansprüche 1 bis 10, dadurch gekennzeichnet, daß von beiden Seiten des ringförmigen Hohlleiterresonators (3) zwei Magnetspulen (12) zur Erzeugung der Elektronen-Zyklotron-Resonanz-Zonen (13) angebracht sind.

13. Vorrichtung nach einem der Ansprüche 10 bis 12, dadurch gekennzeichnet, daß ein Verbund aus senkrecht zu der Plasmakammerwand (35) polarisierten Permanentmagneten (14) zwischen der Innenwand (26) des ringförmigen Hohlleiterresonators (3) und der Plasmakammerwand (35) zur Erzeugung der Elektronen-Zyklotron-Resonanz-Zonen (13) im Plasma (1) angebracht ist.

14. Vorrichtung nach einem der Ansprüche 2 bis 13 dadurch gekennzeichnet, daß an jedem Koppelschlitz (4) zwei gleich polarisierte, aber bei zwei benachbarten Fenstern einander entgegengesetzt polarisierte Permanentmagnete (14) angebracht sind.

15. Vorrichtung nach einem der Ansprüche 1 bis 14, dadurch gekennzeichnet, daß mehrere Mikrowellenerzeuger (9) durch mehrere Koppelstellen an den ringförmigen Hohlleiterresonator (3) angeschlossen sind.

16. Vorrichtung nach einem der Ansprüche 1 bis 15, dadurch gekennzeichnet, daß mehrere ringförmige Hohlleiterresonatoren (3) vorgesehen sind, die über einen Speiseresonator (32) miteinander verbunden sind und mit jeweils dergleichen Leistung versorgt werden.

17. Vorrichtung nach einem der Ansprüche 1 bis 16, dadurch gekennzeichnet, daß mehrere ringförmige Hohlleiterresonatoren (3) vorgesehen sind, die von kohärent betriebenen Mikrowellenerzeuger (9) gespeist werden.

18. Vorrichtung nach einem der Ansprüche 16 bis 17, dadurch gekennzeichnet, daß zur optimalen Einstellung einer stehenden Welle in dem Speiseresonator (32) an dessen einer Seite ein Kurzschlußschieber (6) vorgesehen ist.

19. Vorrichtung nach Anspruch 18, dadurch gekennzeichnet, daß der Speiseresonator rechteckig ist.

## Claims

1. A device for producing a low-pressure plasma (1) comprising a plasma chamber (K), a microwave generator (9), a circular-ring-shaped waveguide resonator (3) and a coupling (23, 8, 7 and 10) from the microwave generator (9) to the ring-shaped waveguide resonator (3), characterised by a plurality of coupling slots (4) which are arranged in the inner wall (26) of the ring-shaped waveguide resonator (3) in such manner that they in each case output-couple the same amount of microwave power from the ring-shaped waveguide resonator (3) in which a standing wave is produced and the coupling slots (4) extend in parallel to the generatrix of the circular-cylindrical inner wall (26) of the ring-shaped waveguide resonator (3) and are arranged equidistantly from one another spaced by one waveguide wavelength (36).

2. A device for producing a low-pressure plasma (1) comprising a plasma chamber (K), a microwave generator (9), a circular-ring-shaped waveguide resonator (3) and a coupling (23, 8, 7 and 10) from the microwave generator (9) to the ring-shaped waveguide resonator (3), characterised by a plurality of coupling slots (4) which are arranged in the inner wall (26) of the ring-shaped waveguide resonator (3) in such manner that they in each case output-couple the same amount of microwave power from the ring-shaped waveguide resonator (3) in which a standing wave is produced and the coupling slots (4) extend in parallel to the generatrix of the circular-cylindrical inner wall (26) of the ring-shaped waveguide resonator (3) and are arranged equidistantly from one another spaced by half a waveguide wavelength (36).

3. A device according to Claim 1 or 2, characterised in that the coupling slots (4) output-couple the energy from a standing TE10 wave in the ring-shaped waveguide resonator (3) as a result of the passage of the azimuthal component of the magnetic field (Hx).

4. A device according to Claim 3, characterised in that the length of the coupling slots (4) in each case amounts to half a free-space wavelength.

5. A device according to one of Claims 1 to 4, characterised in that the feeding-in of the microwave energy from the tuning unit (7) into the ring-shaped waveguide resonator (3) is effected by a capacitive output-coupler (5).

6. A device according to one of Claims 1 to 5, characterised in that the feeding-in of the microwave energy from the tuning unit (7) into the ring-shaped waveguide resonator (3) is effected by an inductive output-coupler.

7. A device according to one of Claims 1 to 6, characterised in that the feeding-in of the microwave energy from the tuning unit (7) into the ring-shaped waveguide resonator is effected by a coupling pin (33) which is adjustable in particular in the axial direction.

8. A device according to one of Claims 1 to 7, characterised in that the plasma chamber (K) is separated from the inner wall (26) of the ring-shaped waveguide resonator (3) by a cylinder composed of dielectric material (2).

9. A device according to Claim 8, characterised in that the cylinder (2) consists of quartz glass or aluminium-oxide-ceramic.

10. A device according to one of Claims 1 to 7, characterised in that the input-coupling of the microwave power into a plasma chamber (K) made of metal takes place through vacuum-tight windows (11) composed of dielectric material.

11. A device according to one of Claims 1 to 10, characterised in that a magnet coil (12) for generating the electron-cyclotron-resonance zones (13) is arranged on one side of the ring-shaped waveguide resonator (3).

12. A device according to one of Claims 1 to 10, characterised in that two magnet coils (12) for generating the electron-cyclotron-resonance zones (13) are arranged on both sides of the ring-shaped waveguide resonator (3).

13. A device according to one of Claims 10 to 12, characterised in that a composite arrangement of permanent magnets (14), polarised at right angles to the plasma chamber wall (35), is arranged between the inner wall (26) of the ring-shaped waveguide resonator (3) and the plasma chamber wall (35) for generating the electron-cyclotron-resonance zones (13) in the plasma (1).

14. A device according to one of Claims 2 to 13, characterised in that at each coupling slot (4) there are arranged two permanent magnets (14) with the same polarity, which however are oppositely polarised in the case of two adjacent windows.

15. A device according to one of Claims to 14, characterised in that a plurality of microwave generators (9) are connected to the ring-shaped waveguide resonator (3) by a plurality of coupling points.

16. A device according to one of Claims 1 to 15, characterised in that a plurality of ring-shaped waveguide resonators (3) are provided which are connected to one another via a supply resonator (32) and are in each case supplied with the same power.

17. A device according to one of Claims 1 to 16, characterised in that a plurality of ring-shaped waveguide resonators (3) are provided which are supplied by coherently operated microwave generators (9).

18. A device according to Claim 16 or Claim 17, characterised in that for the optimal adjustment of a standing wave in the supply resonator (32) a short-circuiting slide (6) is provided on one side of said supply resonator (32) .

19. A device according to Claim 18, characterised in that the supply resonator (32) is of rectangular formation.

## Revendications

1. Dispositif de production d'un plasma basse pression (1) équipé d'une chambre à plasma (K), d'un générateur à micro-ondes (9), d'un résonateur à conducteur creux (3) en forme d'anneau de cercle et d'un organe de couplage (23, 8, 7 et 10) pour le couplage du générateur à micro-ondes (9) au résonateur à conducteur creux (3) en forme d'anneau, caractérisé par le fait de comprendre plusieurs fentes de couplage (4), qui sont disposées dans la paroi intérieure (26) du résonateur à conducteur creux (3) en forme d'anneau, de manière à ce qu'elles découplent chaque fois une puissance à micro-ondes d'égale valeur à partir du résonateur à conducteur creux (3) en forme d'anneau dans lequel est produite une onde stationnaire et les fentes de couplage (4) s'étendent parallèlement à la ligne d'enveloppe de la paroi intérieure (26) cylindrique circulaire du résonateur à conducteur creux (3) en forme d'anneau et sont disposées de façon équidistante les unes des autres, à la distance de la longueur d'ondes du conducteur creux (36).

2. Dispositif de production d'un plasma à basse pression (1) équipé d'une chambre à plasma (K), d'un générateur à micro-ondes (9), d'un résonateur à conducteur creux (3) en forme d'anneau de cercle et d'un organe de couplage (23, 8, 7 et 10) pour le couplage du générateur à micro-ondes (9) sur le résonateur à conducteur creux (3) en forme d'anneau, caractérisé par le fait de comprendre plusieurs fentes de couplage (4), qui sont disposées dans la paroi intérieure (26) du résonateur à conducteur creux (3) en forme d'anneau, de manière qu'elles découplent chaque fois une puissance à micro-ondes d'égale valeur à partir du résonateur à conducteur creux (3) en forme d'anneau, dans lequel est produite une onde stationnaire, et les fentes de couplage (4) s'étendent parallèlement par rapport à la ligne d'enveloppe de la paroi intérieure (26) cylindrique circulaire du résonateur à conducteur creux (3) en forme d'anneau et sont disposées de façon équidistante les unes des autres, à la distance de la moitié de la longueur d'ondes de conducteur creux (36).

3. Dispositif selon la revendication 1 ou la revendication 2, caractérisé en ce que les fentes de couplage (4) découplent l'énergie à partir d'une onde TE10 stationnaire, à partir d'un résonateur à conducteur creux (3) en forme d'anneau, par la pénétration de la composante azimutale du champ magnétique (Hx).

4. Dispositif selon la revendication 3, caractérisé en ce que la longueur des fentes de couplage (4) correspond pour chacune à la moitié de la longueur d'ondes de l'espace libre.

5. Dispositif selon l'une des revendications 1 à 4, caractérisé en ce que l'injection de l'énergie à micro-ondes s'effectue à partir de l'unité de syntonisation (7) dans le résonateur à conducteur creux (3) en forme d'anneau, au moyen d'un découpleur capacitif (5).

6. Dispositif selon l'une des revendications 1 à 5, caractérisé en ce que l'injection de l'énergie à micro-ondes s'effectue à partir de l'unité de syntonisation (7) dans le résonateur à conducteur creux (3) en forme d'anneau, par un découpleur inductif.

7. Dispositif selon l'une des revendications 1 à 6, caractérisé en ce que l'injection de l'énergie à micro-ondes à partir de l'unité de syntonisation (7) dans le résonateur à conducteur creux en forme d'anneau s'effectue au moyen d'une tige de couplage (33) réglable, en particulier en direction axiale.

8. Dispositif selon l'une des revendications 1 à 7, caractérisé en ce que la chambre à plasma (K) est délimitée par la paroi intérieure (26) du résonateur à conducteur creux (3) en forme d'anneau, au moyen d'un cylindre constitué en diélectrique (2).

9. Dispositif selon la revendication 8, caractérisé en ce que le cylindre (2) est constitué en verre de quartz ou en céramique à base d'oxyde d'aluminium.

10. Dispositif selon l'une des revendications 1 à 7, caractérisé en ce que le couplage de la puissance à micro-ondes s'effectue dans une chambre à plasma (K) en métal, au travers d'une fenêtre (11) étanche au vide et constituée en un diélectrique.

11. Dispositif selon l'une des revendications 1 à 10, caractérisé en ce que, sur un côté du résonateur à conducteur creux (3) en forme d'anneau, est montée une bobine magnétique (12) destinée à produire les zones de résonance cyclotron des électrons (13).

12. Dispositif selon l'une des revendications 1 à 10, caractérisé en ce que, des deux côtés du résonateur à conducteur creux (3) en forme d'anneau, sont montées deux bobines magnétiques (12) destinées à produire les zones de résonance cyclotron à électrons (13).

13. Dispositif selon l'une des revendications 10 à 12, caractérisé en ce qu'un composite, constitué d'aimants permanents (14) polarisés perpendiculairement par rapport à la paroi de chambre à plasma (35), est monté entre la paroi intérieure (26) du résonateur à conducteur creux (3) en forme d'anneau et la paroi à chambre à plasma (35), en vue de produire les zones de résonance cyclotron à électrons (13) dans le plasma (1).

14. Dispositif selon l'une des revendications 2 à 13, caractérisé en ce que sur chaque fente de couplage (4) sont montés deux aimants permanents (14), de polarisation identique, mais polarisés à l'opposé l'un de l'autre pour deux fenêtres voisines.

15. Dispositif selon l'une des revendications 1 à 14, caractérisé en ce que plusieurs générateurs à micro-ondes (9) sont raccordés au résonateur à conducteur creux (3) en forme d'anneau, au moyen de plusieurs points de couplage.

16. Dispositif selon l'une des revendications 1 à 15, caractérisé en ce que plusieurs résonateurs à conducteur creux (3) en forme d'anneaux sont prévus, qui sont reliés ensemble par l'intermédiaire d'un résonateur d'injection (32) et sont alimentés chaque fois avec la même puissance.

17. Dispositif selon l'une des revendications 1 à 16, caractérisé en ce que plusieurs résonateurs à conducteur creux (3) en forme d'anneaux sont prévus, qui sont alimentés par un générateur à micro-ondes (9) à fonctionnement cohérent.

18. Dispositif selon la revendication 16 ou la revendication 17, caractérisé en ce que, pour obtenir un réglage optimal d'une onde stationnaire dans le résonateur d'injection (32), un curseur à court-circuit (6) est prévu sur un côté de celui-ci.

19. Dispositif selon la revendication 18, caractérisé en ce que le résonateur d'injection (32) est de configuration rectangulaire.
